# DEMANDE DE BREVET EUROPEEN

(11) **EP 4 583 401 A1**
(43) Date de publication de la demande: **09.07.2025**
(21) Numéro de dépôt: 24220415.4
(22) Date de dépôt: 17.12.2024
(51) Int. Cl.: H03H 3/02, H03H 3/08, H03H 9/02, H03H 3/04, H03H 9/17, H01L 21/3105, H01L 21/20, H10N 30/00, H10N 30/072, H10N 30/086

(54) **PROCÉDÉ D'AMINCISSEMENT D'UNE COUCHE EN UN MATÉRIAU PIÉZOÉLECTRIQUE**

(30) Priorité: 18.12.2023 FR 2314364
(71) Demandeur: Commissariat à l'Energie Atomique et aux Energies Alternatives, 75015 Paris (FR)
(72) Inventeur: BOUSQUET, Marie, 38054 GRENOBLE CEDEX 09 (FR); PERREAU, Pierre, 38054 GRENOBLE CEDEX 09 (FR); ENYEDI, Grégory, 38054 GRENOBLE CEDEX 09 (FR); COIG, Marianne, 38054 GRENOBLE CEDEX 09 (FR)
(74) Mandataire: Cabinet Beaumont

(57) **Abrégé**

La présente description concerne un procédé d'amincissement d'une première couche (10) en un matériau piézoélectrique comprenant :
a. l'implantation d'ions dans la première couche (10) de manière à amorphiser une partie supérieure (10a) de la première couche (10), et
b. le retrait de la partie supérieure (10a) par une étape de polissage mécanochimique.

## Description

### Domaine technique

La présente description concerne de façon générale les dispositifs électroniques et leurs procédés de fabrications. Plus particulièrement, la présente description concerne les dispositifs électroniques comprenant des couches piézoélectriques et leurs procédés de fabrication.

### Technique antérieure

Il existe des procédés connus de fabrication d'un dispositif comprenant une couche mince d'un matériau piézoélectrique sur un substrat. Par exemple, le document WO 2019/002080 enseigne un procédé dit Smart Cut^{™} de transfert d'une couche mince depuis un support sur un substrat.

Le procédé dit Smart Cut^{™}, ainsi que d'autres procédés de fabrication d'un dispositif comprenant une couche d'un matériau piézoélectrique sur un substrat, comprennent une étape d'amincissement par meulage ("grinding") de la couche de matériau piézoélectrique. Cette étape de meulage entraine des défauts de surface sur la couche de matériau piézoélectrique.

### Résumé de l'invention

Un mode de réalisation prévoit un procédé d'amincissement d'une première couche en un matériau piézoélectrique comprenant : a. l'implantation d'ions dans la première couche de manière à amorphiser une partie supérieure de la première couche, et b. le retrait de la partie supérieure par une étape de polissage mécanochimique.

Selon un mode de réalisation, la première couche est dans un matériau parmi LiNbO₃, LiTaO₃, quartz, langasite, langatate, KNbO₃, K(Ta, Nb)O₃, SrTiO₃ ou Pb(Zr, Ti)O₃.

Selon un mode de réalisation, les ions comprennent des ions d'hydrogène et/ou d'hélium et/ou d'oxygène.

Selon un mode de réalisation, la première couche est située sur un substrat.

Selon un mode de réalisation, la première couche est obtenue par une étape de meulage.

Selon un mode de réalisation, le procédé comprend une étape de recuit entre les étapes a. et b.

Selon un mode de réalisation, les caractéristiques de l'étape a. sont telles que la vitesse de retrait de la partie supérieure de la première couche par polissage est au moins 10 % plus rapide que la vitesse de retrait d'une partie inférieure n'ayant pas reçu d'ions de la première couche par polissage.

Selon un mode de réalisation, la partie inférieure a une épaisseur inférieure à 10 µm.

Selon un mode de réalisation, la partie inférieure a une épaisseur inférieure à 1 µm.

Selon un mode de réalisation, le procédé comprend plusieurs étapes distinctes d'implantation d'ions.

Un autre mode de réalisation prévoit un procédé de fabrication d'un filtre à ondes acoustiques de surface comprenant : la formation d'une première couche en un matériau piézoélectrique sur un substrat ; l'amincissement de la première couche par un procédé tel que décrit précédemment ; la formation d'électrodes ayant des formes de peignes interdigitées sur la première couche.

Un autre mode de réalisation prévoit un procédé de fabrication d'un filtre à ondes acoustiques de volume comprenant : la formation d'une deuxième couche sur un substrat ; la formation d'une première région conductrice ou semiconductrice dans la deuxième couche ; la formation d'une première couche sur la deuxième couche ; l'amincissement de la première couche par un procédé tel que décrit précédemment ; la formation d'une cavité traversant la première couche de manière à atteindre la première région conductrice ou semiconductrice ; la formation d'une deuxième région conductrice sur la première couche.

Selon un mode de réalisation, la deuxième couche est un miroir de Bragg.

Selon un mode de réalisation, le procédé comprend la formation d'une cavité comprenant un élément gazeux entre une partie de la première région et la deuxième couche.

Selon un mode de réalisation, le filtre est adapté aux radio fréquences.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1A représente une étape d'un procédé d'amincissement ;
la figure 1B représente une autre étape du procédé de la figure 1A ;
la figure 1C représente une autre étape du procédé de la figure 1A ;
la figure 2 représente une étape d'un autre procédé d'amincissement ;
la figure 3 représente un filtre comprenant une couche piézoélectrique ;
la figure 4 représente un filtre comprenant une couche piézoélectrique ; et
la figure 5 représente un filtre comprenant une couche piézoélectrique.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près.

On définit un matériau piézoélectrique comme un matériau ayant la propriété de se polariser électriquement sous l'action d'une contrainte mécanique et réciproquement de se déformer lorsqu'un champ électrique lui est appliqué. Une catégorie de matériau piézoélectrique correspond aux matériaux ferroélectriques, c'est-à-dire les matériaux possédant une polarisation électrique à l'état naturel, polarisation qui peut être renversée par l'application d'un champ électrique extérieur. Une autre catégorie de matériau piézoélectrique correspond aux matériaux pyroélectriques, c'est-à-dire les matériaux dans lesquels une variation de polarisation électrique peut être générée par un changement de température du matériau.

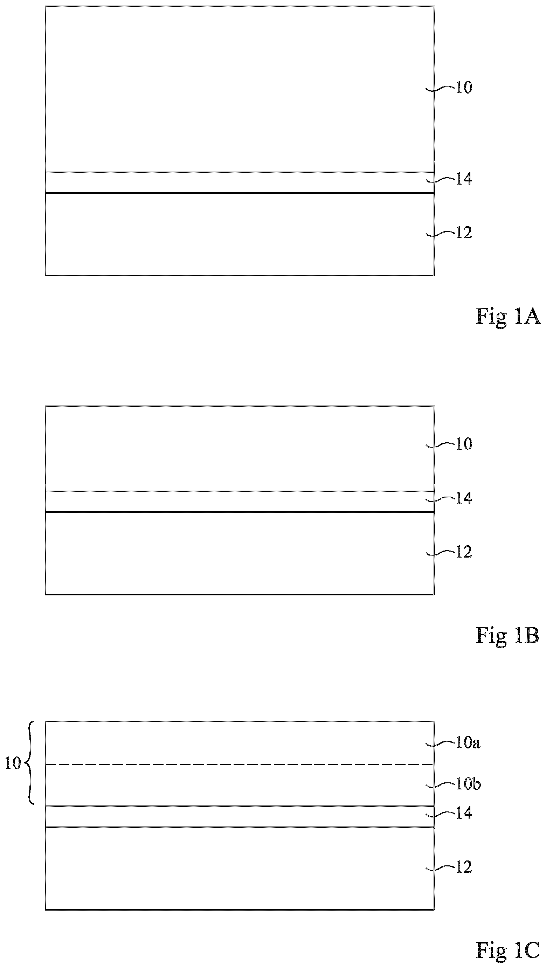

Les figures 1A, 1B et 1C représentent des étapes, de préférence successives, d'un procédé d'amincissement d'une couche en un matériau piézoélectrique. Le procédé des figures 1A, 1B, 1C permet par exemple d'obtenir une couche dite mince en un matériau piézoélectrique. La couche mince voulue est de préférence plane, c'est-à-dire ayant des faces supérieures et inférieures, opposées l'une à l'autre, parallèles et planes.

La figure 1A représente une étape d'un procédé d'amincissement.

Au cours de cette étape, une couche 10 d'un matériau piézoélectrique est fixée sur un support 12.

Le support 12 est par exemple un substrat semiconducteur, par exemple en silicium (Si), en carbure de silicium (SiC) ou en diamant. Par exemple, le support 12 correspond au substrat manipulateur, également appelé substrat poignée, ou base, du procédé d'amincissement.

Alternativement, le support 12 peut comprendre plusieurs matériaux, par exemple plusieurs couches de matériaux différents. Le support 12 correspond par exemple au substrat d'une puce sur laquelle un filtre peut être formé.

La couche 10 est en un matériau piézoélectrique, de préférence en un matériau piézoélectrique monocristallin. La couche 10 est par exemple en un matériau ferroélectrique ou en un matériau pyroélectrique. Par exemple la couche 10 est en LiNbO₃, en LiTaO₃, en quartz, en langasite, en langatate, en KNbO₃, en K(Ta, Nb)O₃, en SrTiO₃ ou en Pb(Zr, Ti)O₃.

La couche 10 correspond par exemple à un bloc massif de matériau piézoélectrique. La couche 10 est par exemple obtenu à partir d'un lingot en matériau piézoélectrique ayant été découpé et aminci de manière à obtenir ledit bloc massif.

La couche 10 est fixée au support 12. La couche est par exemple fixée par adhésion moléculaire. La couche 10 est par exemple fixée au support 12 par une couche de fixation 14, ou couche de collage 14. La couche 14 est par exemple en un matériau diélectrique, par exemple en oxyde de silicium (SiO₂), en nitrure de silicium (SiN), en Al₂O₃ ou en HfO₂, en un polymère ou en un métal, par exemple en or, en tungstène, en platine ou en titane.

Autrement dit, le support 12 comprend une face supérieure, c'est-à-dire la face la plus proche de la couche 10, recouverte par la couche de fixation 14, plus précisément par une face inférieure de la couche de fixation 14. La couche de fixation 14 est recouverte par la couche 10. Plus précisément, la face supérieure de la couche de fixation 14 est recouverte par une face inférieure de la couche 10.

L'épaisseur du support 12 est par exemple comprise entre 50 µm et 2000 mm, par exemple sensiblement égale à 100 µm, 150 µm ou 200 µm.

L'épaisseur de la couche 10 est supérieure à l'épaisseur voulue après l'application du procédé d'amincissement. La couche 10 a par exemple une épaisseur comprise entre 5 et 2000 µm.

La figure 1B représente une autre étape du procédé de la figure 1A.

L'étape de la figure 1B correspond à une première étape d'amincissement. Cette étape d'amincissement retire par exemple une partie importante de l'épaisseur de la couche 10, par exemple au moins la moitié de la couche 10. Il s'agit de préférence d'une étape de meulage.

L'étape de la figure 1B, c'est-à-dire l'étape de meulage, engendre la formation de défauts au niveau de la face supérieure de la couche 10, c'est-à-dire au niveau de la face meulée. Lesdits défauts de surface correspondent par exemple à un manque d'uniformité de l'épaisseur de la couche 10, par exemple à des fissures dans la couche 10. Ainsi, certaines régions de la couche 10 après meulage comprennent des cavités non voulues au niveau de la face supérieure. En outre, l'étape de meulage peut avoir généré des dégradations de caractéristiques électriques de la couche 10 au niveau de la face supérieure.

L'épaisseur de la couche 10 après l'étape de meulage est supérieure à l'épaisseur voulue après l'application du procédé d'amincissement. Plus précisément, l'étape de meulage est telle que l'épaisseur de la couche 10 après le meulage soit supérieure à la somme de l'épaisseur voulue après l'application du procédé d'amincissement et de l'épaisseur maximale des défauts générés par le meulage. Par exemple, l'épaisseur de la couche 10 après l'étape de la figure 1B est comprise entre 15 µm et 50 µm.

La figure 1C représente une autre étape du procédé de la figure 1A.

Au cours de cette étape, une partie supérieure 10a est formée dans la couche 10. La partie 10a s'étend à partir de la face supérieure de la couche 10. La partie 10a s'étend vers la face inférieure de la couche 10. La partie 10a correspond à toute la partie supérieure de la couche 10.

La couche 10 a en outre une partie inférieure 10b. La partie 10b correspond à toute la partie de la couche 10 s'étendant entre la partie 10a et le support 12. Ainsi, la couche 10 correspond à un empilement de la partie 10b et de la partie 10a.

La partie 10b a une épaisseur supérieure ou égale, de préférence sensiblement égale, à la hauteur de la couche 10 voulue après le procédé d'amincissement. La partie 10a a une épaisseur supérieure ou égale, de préférence supérieure, à la hauteur maximale des défauts de surface générés par le meulage.

La partie 10a est obtenue par l'introduction dans la couche 10 d'au moins une espèce dite légère. L'introduction de ladite espèce légère correspond par exemple à une implantation, c'est à dire à un bombardement ionique de la face supérieure de la couche 10 par des ions légers, par exemple des ions d'hydrogène et/ou hélium et/ou d'oxygène, et éventuellement par des ions plus lourds, par exemple de l'argon ou du carbone. Par exemple, la partie 10a est obtenue par une cointégration, c'est-à-dire l'intégration de plusieurs ions. La partie 10a correspond ainsi à une partie dite amorphisée, ou endommagée, de la couche 10.

La nature, la dose des espèces implantées et l'énergie d'implantation sont choisies en fonction de l'épaisseur des défauts et l'épaisseur de l'amincissement voulu. Il est ainsi possible de former une couche, correspondant à la partie 10b, ayant, selon les applications, une épaisseur supérieure à 10 µm, une épaisseur comprise entre 1 µm et 10 µm, ou une épaisseur inférieure à 1 µm.

Le procédé d'implantation d'ion, très homogène à l'échelle d'une plaque, assure que la partie 10a a une face inférieure plane, de préférence parallèle à la face inférieure de la couche 10, de préférence parallèle à la face supérieure de la couche 10.

L'étape de la figure 1C comprend par exemple une étape de recuit de la structure.

Le procédé d'amincissement comprend, après l'étape de la figure 1C, une étape de polissage mécanochimique (CMP - Chemical Mechanical Polishing). L'étape de polissage permet de retirer la partie 10a. La couche formée par le procédé d'amincissement correspond ainsi à la partie 10b.

La dégradation de la partie 10a de la couche 10 de matériau piézoélectrique entraine une modification de la vitesse de gravure, ou vitesse d'enlèvement, du matériau piézoélectrique de la partie 10b. Ainsi, le matériau de la partie 10a est gravé plus rapidement, par exemple au moins 10% plus rapidement que le matériau de la partie 10a. Par exemple, dans le cas d'une couche 10 en LiNbO₃, la partie 10a est gravée 30% plus rapidement que la partie 10b.

Il est ainsi possible de retirer la partie 10a sans graver ou endommager la partie 10b. La différence de vitesse de gravure assure que les différences de hauteur de la partie 10a causées par les défauts de surface n'impacte pas la face supérieure de la partie 10b. La partie 10b a ainsi une face supérieure plane, sans défauts de surface causés par le meulage.

A titre de variante, le procédé des figures 1A à 1C peut être utilisé pour diminuer une non uniformité après un polissage et avant une étape d'abrasion locale ("trimming").

A titre de variante, les couches 10 et 14 peuvent être remplacées par une couche de matériau piézoélectrique obtenue par dépôt physique (Physical Vapour Déposition) ou chimique (Chemical Vapour Déposition).

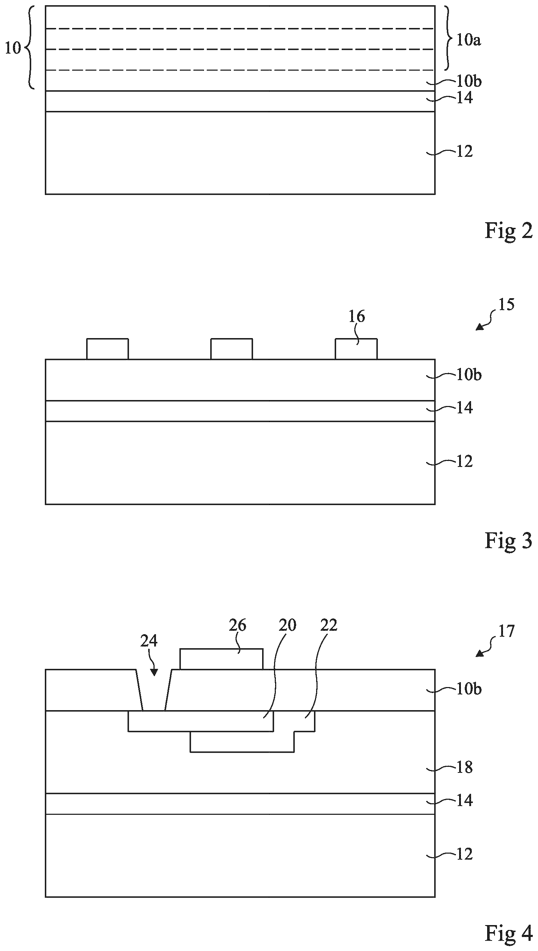

La figure 2 représente une étape d'un autre procédé d'amincissement. Plus précisément, la figure 2 illustre une variante du procédé de fabrication des figures 1A à 1C. La variante de la figure 2 est par exemple particulièrement adaptée à la formation d'une couche fine, par exemple inférieure à 10 µm. La figure 2 illustre plus précisément une variante de l'étape de la figure 1C.

Le procédé illustré par la figure 2 comprend, comme le procédé des figures 1A à 1C, les étapes des figures 1A et 1B.

L'étape de la figure 2 diffère de l'étape de la figure 1C en ce que la couche 10 subit, avant l'étape de polissage, plusieurs implantations d'ions, chaque implantation étant représentée par un trait en pointillés en figure 2. Plus précisément, les traits pointillés indiquent le niveau inférieur de la partie recevant les ions pour chaque implantation. Chaque implantation est par exemple suivie d'un recuit. Chaque implantation est effectuée à une profondeur différente. Les implantations peuvent être faite à des profondeurs par exemple inférieures à 500 nm, par exemple inférieures à 300 nm, par exemple inférieure à 200 nm.

Au moins certaines des différentes implantations sont par exemple effectuées avec des ions différents, et/ou des niveaux d'énergies différents.

La figure 3 représente un filtre 15 comprenant une couche piézoélectrique 10b. Plus précisément, la figure 3 représente un filtre 15 à ondes acoustiques de surface (SAW ou Surface Acoustic Wave).

Le filtre 15 comprend les couches 12 et 14 décrites précédemment et une couche 10b obtenue par un des modes de réalisation décrits précédemment.

Le procédé de fabrication, et en particulier les caractéristiques de l'implantation ionique, est par exemple configuré pour que la couche 10b ait une épaisseur comprise entre 15 µm et 50 µm.

Le filtre 15 comprend en outre des électrodes 16 situées sur la face supérieure de la couche 10b. Les électrodes 16 ont des formes de peignes interdigitées, de telle manière que les ondes acoustiques se propagent à la surface du matériau piézoélectrique de la couche 10b.

La figure 4 représente un autre filtre 17 comprenant une couche piézoélectrique 10b. Plus précisément, la figure 4 représente un filtre 17 à ondes acoustiques de volume (BAW ou Bulk Acoustic Wave). La filtre 17 est par exemple de type résonateurs acoustiques à ondes de volume auto suspendu (FBAR ou film bulk acoustic resonator), dans lequel l'isolation acoustique est assurée par une cavité d'air 22. Par exemple, le filtre 17 est adapté au ondes radio fréquences.

Le filtre 17 comprend les couches 12 et 14 décrites précédemment et une couche 10b obtenue par un des modes de réalisation décrits précédemment.

Le filtre 17 comprend, en outre, une couche 18 située entre la couche 14 de fixation et la couche 10b. La couche 18 est par exemple une couche en un matériau isolant. La couche 18 est par exemple en oxyde de silicium.

Le filtre 17 comprend en outre une région conductrice ou semiconductrice 20 et une cavité 22 dans la couche 18, c'est-à-dire entre la couche 14 et la couche 10b.

La région 20 constitue une électrode inférieure du filtre. La couche 20 est par exemple en métal. La couche 20 affleure de préférence la face supérieure de la couche 18. Ainsi, la face supérieure de la région 20 est de préférence coplanaire avec la face supérieure de la couche 18. De préférence, la région 20 repose partiellement sur la couche 18. Ainsi, une partie de la face inférieure de la région 20 est en contact avec la couche 18.

La cavité 22 est par exemple remplie d'un élément gazeux, par exemple d'air. La cavité 22 s'étend sous une partie de la région 20. Ainsi, une partie de la face inférieure de la région 22 constitue une partie des parois de la cavité 22. La cavité 22 s'étend par exemple jusqu'à la face supérieure de la couche 18, par exemple au niveau d'une paroi latérale de la région 20. La cavité 22 atteint ainsi la face inférieure de la couche 10b. La cavité est délimitée par la couche 18, la région 20 et la couche 10b. La cavité 22 est ainsi par exemple fermée.

La région 20 et la cavité 22 sont par exemple formées avant la formation de la couche 10b. Alternativement, la cavité 22 est remplie d'un matériau sacrificiel jusqu'à la fin de la formation de la couche 10b. Un trou de libération, non représenté, traversant la couche 10b au niveau de la couche 22 est ensuite formée, de manière à retirer le matériau sacrificiel par l'intermédiaire dudit trou de libération.

Le filtre 17 comprend en outre une cavité 24 traversant la couche 10b de manière à atteindre la région 20.

Le filtre 17 comprend en outre une région conductrice ou semiconductrice 26 reposant sur la couche 10b, de préférence en regard d'au moins une partie de la région 20. La région 26 constitue une électrode supérieure du filtre 17.

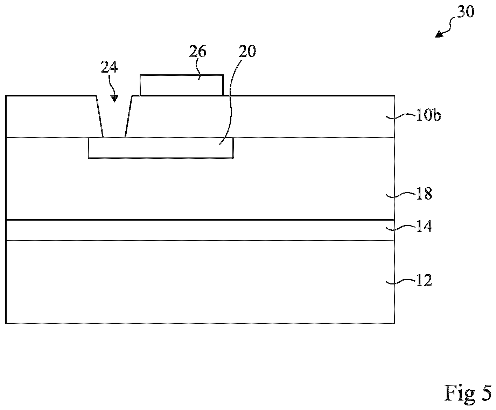

La figure 5 représente un filtre 30 comprenant une couche piézoélectrique 10b. Plus précisément, la figure 5 représente un filtre 30 à ondes acoustiques de volume (BAW ou Bulk Acoustic Wave). La filtre 30 est par exemple de type résonateurs sur réflecteur (ou miroir) de Bragg (SMR ou solidly mounted resonator). Par exemple, le filtre 30 est adapté aux ondes radio fréquences.

Le filtre 30 comprend les couches 12 et 14 décrites précédemment et une couche 10b obtenue par un des modes de réalisation décrits précédemment.

Le filtre 30 comprend, en outre, la couche 18 située entre la couche 14 de fixation et la couche 10b. La couche 18 est par exemple une couche en un matériau isolant. La couche 18 est par exemple en oxyde de silicium.

Le filtre 30 comprend en outre la région conductrice ou semiconductrice 20 dans la couche 18, c'est-à-dire entre la couche 14 et la couche 10b.

La région 20 constitue comme précédemment une électrode inférieure du filtre. La couche 20 est par exemple en métal. La couche 20 affleure de préférence la face supérieure de la couche 18. Ainsi, la face supérieure de la région 20 est de préférence coplanaire avec la face supérieure de la couche 18.

Le filtre 30 diffère du filtre 17, entre autres, en ce que le filtre 30 ne comprend pas la cavité 22. Ainsi, la région 20 repose entièrement sur la couche 18. Autrement dit, la face inférieure, et de préférence les parois latérales, de la région 20 sont entièrement en contact avec la couche 18.

La région 20 est par exemple formée avant la formation de la couche 10b. Le filtre 30 comprend en outre la cavité 24, ou trou de libération 24, traversant la couche 10b de manière à atteindre la région 20, permettant l'accès à l'électrode inférieure 20.

Le filtre 30 comprend en outre la région conductrice 26 reposant sur la couche 10b, de préférence en regard d'au moins une partie de la région 20. La région 26 constitue une électrode du filtre 30. La couche 18 constitue le miroir de Bragg, c'est-à-dire une alternance de couches minces de matériaux ayant une faible impédance acoustique, par exemple SiO₂, SiOC, SiON, et de couches minces de matériaux ayant une forte impédance acoustique, par exemple AlN, W, TaN, Ta₂O₅, WO₂, WN, HfO₂, ou HfN, permettant d'isoler acoustiquement le résonateur du substrat.

Un avantage des modes de réalisation décrits précédemment est qu'ils permettent de former des couches fines de matériau piézoélectrique ne comprenant pas de défauts de surface.

Divers modes de réalisation et variantes ont été décrits. La personne du métier comprendra que certaines caractéristiques de ces divers modes de réalisation et variantes pourraient être combinées, et d'autres variantes apparaîtront à la personne du métier.

Enfin, la mise en oeuvre pratique des modes de réalisation et variantes décrits est à la portée de la personne du métier à partir des indications fonctionnelles données ci-dessus.

## Revendications

1. Procédé d'amincissement d'une première couche (10) en un matériau piézoélectrique comprenant :
a. au moins deux implantations d'ions dans la première couche (10) de manière à amorphiser une partie supérieure (10a) de la première couche (10), la partie supérieure s'étendant à partir d'une face supérieure de la première couche, les implantations étant faites à des profondeurs différentes, et
b. le retrait de la partie supérieure (10a) par une étape de polissage mécanochimique.

2. Procédé selon la revendication 1, dans lequel la première couche (10) est dans un matériau parmi LiNbO₃, LiTaO₃, quartz, langasite, langatate, KNbO₃, K(Ta, Nb)O₃, SrTiO₃ ou Pb(Zr, Ti)O₃.

3. Procédé selon la revendication 1 ou 2, dans lequel les ions comprennent des ions d'hydrogène et/ou d'hélium et/ou d'oxygène.

4. Procédé selon l'une quelconque des revendications 1 à 3, dans lequel la première couche (10) est située sur un substrat (12).

5. Procédé selon l'une quelconque des revendications 1 à 4, dans lequel la première couche (10) est obtenue par une étape de meulage.

6. Procédé selon l'une quelconque des revendications 1 à 5, dans lequel le procédé comprend une étape de recuit entre les étapes a. et b.

7. Procédé selon l'une quelconque des revendications 1 à 6, dans lequel les caractéristiques de l'étape a. sont telles que la vitesse de retrait de la partie supérieure (10a) de la première couche par polissage est au moins 10 % plus rapide que la vitesse de retrait d'une partie inférieure (10b) n'ayant pas reçu d'ions de la première couche par polissage.

8. Procédé selon la revendication 7, dans lequel la partie inférieure (10b) a une épaisseur inférieure à 10 µm.

9. Procédé selon la revendication 7 ou 8, dans lequel la partie inférieure (10b) a une épaisseur inférieure à 1 µm.

10. Procédé selon l'une quelconque des revendications 1 à 9, dans lequel le procédé comprend plusieurs étapes distinctes d'implantation d'ions.

11. Procédé selon l'une quelconque des revendications 1 à 10, dans lequel les implantations ont des profondeurs inférieures à 500 nm.

12. Procédé de fabrication d'un filtre à ondes acoustiques de surface comprenant :
la formation d'une première couche en un matériau piézoélectrique sur un substrat ;
l'amincissement de la première couche par un procédé selon l'une quelconque des revendications 1 à 11 ;
la formation d'électrodes (16) ayant des formes de peignes interdigitées sur la première couche.

13. Procédé de fabrication d'un filtre à ondes acoustiques de volume comprenant :
la formation d'une deuxième couche (18) sur un substrat ;
la formation d'une première région conductrice (20) ou semiconductrice dans la deuxième couche ;
la formation d'une première couche sur la deuxième couche ;
l'amincissement de la première couche par un procédé selon l'une quelconque des revendications 1 à 11 ;
la formation d'une cavité (24) traversant la première couche de manière à atteindre la première région conductrice ou semiconductrice ;
la formation d'une deuxième région conductrice (26) sur la première couche (10b).

14. Procédé selon la revendication 13, dans lequel la deuxième couche (18) est un miroir de Bragg.

15. Procédé selon la revendication 14, dans lequel le procédé comprend la formation d'une cavité (22) comprenant un élément gazeux entre une partie de la première région et la deuxième couche.

16. Procédé selon l'une quelconque des revendications 12 à 15, dans lequel le filtre est adapté aux radio fréquences.
